(19) Europäisches Patentamt
European Patent Office
Office européen des brevets

(11) Veröffentlichungsnummer: **0 592 471 B1**

(12) # EUROPÄISCHE PATENTSCHRIFT

(45) Veröffentlichungstag der Patentschrift: **27.12.95**

(51) Int. Cl.6: **C08J 7/14**, C23C 18/24, //C08L77/00

(21) Anmeldenummer: **92912345.3**

(22) Anmeldetag: **11.06.92**

(86) Internationale Anmeldenummer:
**PCT/EP92/01312**

(87) Internationale Veröffentlichungsnummer:
**WO 93/00392 (07.01.93 93/02)**

(54) **VERFAHREN ZUR OBERFLÄCHENBEHANDLUNG VON POLYAMID-FORMKÖRPERN UND DANACH ERHALTENE FORMKÖRPER**

(30) Priorität: **22.06.91 DE 4120723**

(43) Veröffentlichungstag der Anmeldung:
**20.04.94 Patentblatt 94/16**

(45) Bekanntmachung des Hinweises auf die Patenterteilung:
**27.12.95 Patentblatt 95/52**

(84) Benannte Vertragsstaaten:
**BE DE FR GB NL**

(56) Entgegenhaltungen:
**DE-A- 3 137 587**
**GB-A- 2 018 791**
**US-A- 3 556 882**

(73) Patentinhaber: **BASF Aktiengesellschaft**
**Carl-Bosch-Strasse 38**
**D-67063 Ludwigshafen (DE)**

(72) Erfinder: **ZEINER, Hartmut**
**Paracelsusstrasse 18**
**D-6700 Ludwigshafen (DE)**
Erfinder: **BETZ, Walter**
**Weimarer Strasse 45**
**D-6700 Ludwigshafen (DE)**
Erfinder: **MC KEE, Graham, Edmund**
**Kastanienstrasse 8**
**D-6940 Weinheim (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services
(3.10/3.09/3.3.3)

## Beschreibung

Die vorliegende Erfindung betrifft ein Verfahren zur Oberflächenbehandlung von Formkörpern auf der Basis von Polyamiden durch Behandlung mit wäßrigen Säuren.

Darüber hinaus betrifft die Erfindung nach diesem Verfahren erhältliche Formkörper sowie deren Verwendung zur Metallisierung, d.h. zur Beschichtung mit Metallen.

Polyamide zählen zur Klasse der technischen Kunststoffe und haben in vielen Bereichen weite Verbreitung gefunden.

Ein interessantes Anwendungsgebiet, nämlich der Bereich der metallisierten Werkstoffe ist den Polyamiden bislang jedoch weitgehend verschlossen geblieben. Dies hat seine Ursache hauptsächlich in der unzureichenden Haftung der Metallschicht auf dem Polyamid. Diese Problematik wird in einem Artikel von Seidenspinner (Galvanotechnik 75 (1984), 852), diskutiert und verschiedene Lösungsansätze, z.B. die Behandlung mit wäßriger Salzsäure, angedeutet. In Galvanotechnik 79 (1988), 54 wird ein Verfahren zur Oberflächenbehandlung von Polyamid-Spritzgußteilen beschrieben, nach dem zunächst in einem Palladiumsalze enthaltenden Bad aktiviert und anschließend in einem Calcium- und Aluminiumsalze enthaltenden Bad die Oberfläche aufgerauht wird. Dieses Verfahren ist zum einen wegen der teuren verwendeten Materialien wirtschaftlich von Nachteil, zum anderen können auch die erzielten Haftfestigkeiten noch nicht voll zufriedenstellen.

Aus der EP-A 56 986 sind Polyamid-Formmassen bekannt, die 30 bis 60 Gew.-% Wollastonit als Füllstoff enthalten und sich besonders zur Metallisierung eignen. Die Vorbehandlung wird mit einer 4 bis 15 %igen Lösung von Salzsäure oder Schwefelsäure durchgeführt, wobei durch Angriff an den Füllstoffpartikeln eine Aufrauhung der Oberfläche erzielt wird, d.h. der Füllstoff ist zur Erreichung guter Haftungswerte zwischen Metall und Polyamid zwingend erforderlich. Durch den hohen Füllstoffgehalt wird jedoch die Qualität der Oberfläche beeinträchtigt, was bei Anwendung im dekorativen Bereich von Nachteil ist.

Aus der EP-A 402 750 ist ein Verfahren zur Oberflächenbehandlung und anschließender Metallisierung für Polyamide bekannt. Hierbei werden teilaromatische Copolyamide mit wäßriger $H_3PO_4$ behandelt und metallisiert. Teilkristalline oder amorphe Polyamide, welche aus aromatischen Monomereinheiten aufgebaut werden können, lassen sich jedoch nicht in zufriedenstellender Weise nach diesem Verfahren metallisieren. Die erzielten Haftfestigkeiten sind für einige Anwendungen nicht ausreichend.

Aufgabe der vorliegenden Erfindung war es daher, ein Verfahren zur Oberflächenbehandlung von Formkörpern auf der Basis von Polyamiden zur Verfügung zu stellen, die anschließend gut metallisierbar sein sollten, und welches die vorstehend geschilderten Nachteile nicht aufweist.

Diese Aufgabe wird erfindungsgemäß durch ein Verfahren zur Oberflächenbehandlung von Formkörpern auf der Basis von Polyamiden durch Behandlung mit wäßrigen Säuren gelöst, wobei man Mischungen aus mindestens 20 gew.-%iger wäßriger Salzsäure mit Mono- oder Diethern einer aliphatischen mehrfunktionellen Hydroxyverbindung im Mischungsverhältnis 90:10 bis 10:90 verwendet. Die Angaben in Gewichtsprozent beziehen sich auf den Gehalt HCl bei einer Temperatur von 20 °C, wobei dieser mind. 20 Gew.-%, vorzugsweise mind. 25 Gew.-% und insbesondere mind. 30 Gew.-% beträgt.

Das erfindungsgemäße Verfahren eignet sich zur Oberflächenbehandlung von Formkörpern auf der Basis von Polyamiden, d.h. Formkörper, die als einen wichtigen Bestandteil ein thermoplastisches Polyamid enthalten. Dieses kann gegebenenfalls mit Füllstoffen, die Schlagzähigkeit verbessernden Polymeren, weiteren Polymeren oder mit Flammschutzmitteln modifiziert sein.

Geeignete Polyamide sind an sich bekannt und umfassen die halbkristallinen und amorphen Harze mit Molekulargewichten (Gewichtsmittelwerten) von mindestens 5000, die gewöhnlich als Nylon bezeichnet werden. Solche Polyamide sind z.B. in den amerikanischen Patentschriften 2 071 250, 2 071 251, 2 130 523, 2 130 948, 2 241 322, 2 312 966, 2 512 606 und 3 393 210 beschrieben.

Die Polyamide können z.B. durch Kondensation äquimolarer Mengen einer gesättigten oder einer aromatischen Dicarbonsäure mit 4 bis 12 Kohlenstoffatomen, mit einem Diamin, welches 4 bis 14 Kohlenstoffatome aufweist, hergestellt werden, oder durch Kondensation von w-Aminocarbonsäuren oder Polyaddition von Lactamen. Beispiele für Polyamide sind Polyhexamethylenadipinsäureamid (Nylon 66), Polyhexamethylenazelainsäureamid (Nylon 69), Polyhexamethylensebacinsäureamid (Nylon 610), Polyhexamethylendodecyndisäureamid (Nylon 612), die durch Ringöffnung von Lactamen erhaltenen Polyamide, wie Polycaprolactam, Polylaurinsäurelactam, ferner Poly-11-aminoundecansäure und ein Polyamid aus Di(p-aminocyclohexal)-methan- und Dodecandisäure. Es ist auch möglich, Polyamide zu verwenden, die durch Copolykondensation von zwei oder mehr der obengenannten Polymeren oder ihrer Komponenten hergestellt worden sind, z.B. ein Copolymeres aus Caprolactam, Terephthalsäure und Hexamethylendiamin. Vorzugsweise sind die Polyamide linear und haben Schmelzpunkte von mehr als 200 °C.

Bevorzugte Polyamide sind Polyhexamethylenadipinsäureamid, Polyhexamethylensebacinsäureamid und Polycaprolactam. Die Polyamide weisen im allgemeinen eine relative Viskosität von 2,5 bis 5 auf, bestimmt an einer 1 gew.-%igen Lösung ind 96 %iger Schwefelsäure bei 23 °C, was einem Molekulargewicht (Gewichtsmittelwert) von etwa 15.000 bis etwa 45.000 entspricht. Polyamide mit einer relativen Viskosität von 2,5 bis 4,0, insbesondere 2,6 bis 3,5, werden bevorzugt verwendet.

Verfahren zur Herstellung solcher Polyamide sind an sich bekannt und in der Literatur beschrieben.

Füllstoffe, schlagzäh modifizierende Polymere und Flammschutzmittel für Polyamide sind dem Fachmann an sich bekannt und in der Literatur beschrieben, so daß sich hier nähere Angaben erübrigen.

Nur stellvertretend sei hier als Mischung von Polyamid und einem anderen Polymeren ein Polymer-Blend aus Polyamid und Polyphenylenether genannt.

Die Herstellung der Formkörper aus den vorstehend beschriebenen Polyamidformmassen kann nach den dem Fachmann bekannten Verfahren, z.B. durch Extrusion, Spritzguß oder Blasformen, um nur 3 Verfahren zu nennen, erfolgen. Die Verarbeitungsbedingungen hängen natürlich von der Zusammensetzung der Polyamidformmasse ab und sind dem Fachmann bekannt.

Die Oberflächenbehandlung der Formkörper auf der Basis von Polyamiden erfolgt mit Hilfe einer Mischung aus mind. 20 gew.-%iger HCl und einem Mono- oder Diether einer aliphatischen mehrfunktionellen Hydroxyverbindung im Mischungsverhältnis 90:10 bis 10:90, vorzugsweise 30:70 bis 70:30 und insbesondere 50:50 Vol%.

Zeitdauer und Temperatur der Behandlung hängen dabei voneinander ab; je höher die Temperatur, desto kürzer die Behandlungsdauer. Eine Erhöhung der Konzentration des HCl-Gehaltes ergibt gleichfalls eine kürzere Behandlungsdauer.

Bevorzugt wird eine Temperatur im Bereich von 10 bis 80, insbesondere von 15 bis 45 °C und ganz besonders von 18 bis 35 °C.

Die Behandlungsdauer liegt vorzugsweise im Bereich von 0,5 bis 25 min, insbesondere von 1 bis 15 min, besonders bevorzugt von 5 bis 10 min.

Es hat sich als vorteilhaft herausgestellt, wenn bei einer Konzentration der Salzsäure von 35 bis 37 Gew.-% das Produkt aus Behandlungstemperatur in Grad Celcius und der Behandlungsdauer in Sekunden im Bereich von 1000 bis 21 000 liegt, da bei der Metallisierung derart vorbehandelter Formkörper besonders gute Haftfestigkeitswerte erzielt werden.

Als weiteren Bestandteil der Vorbehandlungsmischung verwendet man vorzugsweise Mono- oder Diether einer aliphatischen mehrfunktionellen Hydroxyverbindung der allgemeinen Formel I

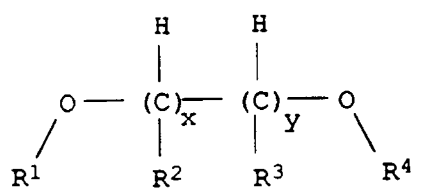

I

wobei

| | |
|---|---|
| $R^1$ | Wasserstoff oder eine $C_1$- bis $C_{10}$-Alkylgruppe, |
| $R^2$ | Wasserstoff oder eine $C_1$- bis $C_{10}$-Alkylgruppe oder eine Hydroxylgruppe, |
| $R^3$ | Wasserstoff oder eine $C_1$- bis $C_{10}$-Alkylgruppe, |
| $R^4$ | Wasserstoff oder eine $C_1$- bis $C_{10}$-Alkylgruppe oder eine $-(CH_2)_n-OR^5$-Gruppe, |
| $R^5$ | Wasserstoff oder eine $C_1$- bis $C_{10}$-Alkylgruppe, |
| x | eine ganze Zahl von 1 bis 10, |
| y | 0 oder 1, |
| n | eine ganze Zahl von 2 bis 4 |

bedeutet.

Bevorzugte Reste $R^1$ sind Methyl, Ethyl, Propyl oder eine n-Butylgruppe, $R^2$ ist bevorzugt Wasserstoff oder eine Methylgruppe sowie eine Hydroxygruppe, wobei bei dem letztgenannten Substituenten x mind. 2 betragen sollte. Für $R^3$ seien als bevorzugte Reste die Methylgruppe oder Wasserstoff genannt, für $R^4$ Wasserstoff und eine $(CH_2)_nOR^5$-Gruppe, in der n vorzugsweise für eine ganze Zahl 2 oder 3 steht und $R^5$ vorzugsweise eine Methylgruppe bedeutet.

Als bevorzugte Verbindungen der allgemeinen Formel seien 1-Methoxy-2-hydroxypropan, (propylenglykol-1-methylether), Dipropylenglykolmonomethylether, Ethylenglykolmonomethylether und Diethylenglykolmonomethylether sowie Di- oder Monomethylether des Glycerins genannt.

Derartige Zusätze sind allgemein bekannt und im Handel erhältlich (z.B. Solvenon® oder Methylglykol).

Nach der Vorbehandlung werden die Formkörper vorteilhafterweise durch Spülen in Wasser von anhaftenden Säureresten befreit.

Im Anschluß daran kann dann der Formkörper in üblicher, an sich bekannter Weise metallisiert werden.

Hierzu wird in der Regel zunächst aktiviert, dann reduziert und anschließend chemisch metallisiert, woran sich die galvanische Metallisierung als letzter Schritt anschließt.

Dabei werden Produkte erhalten, die sich durch besonders hohe Haftfestigkeiten im allgemeinen im Bereich von 1,25 bis 5 N/mm (gemessen nach DIN 53 289 im Rollenschälversuch) auszeichnen.

Durch die Behandlung mit der Salzsäure werden die in der Oberflächenschicht enthaltenen Aminogruppen des Polyamids durch Reaktion mit HCl modifiziert, wobei zur Erzielung besonders guter Ergebnisse in einer Oberflächenschicht von max. 100 mm Dicke mindestens 5 mol% der ursprünglich vorhandenen Aminogruppen verändert werden.

Aus dem Vorstehenden geht bereits hervor, daß sich die erfindungsgemäßen Formkörper insbesondere zur anschließenden Metallisierung eignen. Die so erhaltenen metallisierten Formkörper können in vielen Bereichen, z.B. im Automobilsektor oder auf dem Gebiet der Elektrotechnik und Elektronik eingesetzt werden.

Darüber hinaus lassen sich nach dem erfindungsgemäßen Verfahren behandelte Formkörper auch gut lackieren und bedrucken.

Beispiele

Es wurden folgende Polyamide eingesetzt:

PA(1)

64 Gew.-% eines statistischen Copolyamids mit 85 % wiederkehrenden Einheiten, die sich von Hexamethylenadipinsäureamid und 15 % wiederkehrenden Einheiten, die sich von e-Caprolactam ableiten.

30 Gew.-% Wollastonit

6 Gew.-% Schlagzähmodifier: 59,8 Gew.-% Ethylen

35 Gew.-% n-Butylacrylat

4,5 Gew.-% Acrylsäure

0,7 Gew.-% Maleinsäureanhydrid

(Ultramid®C3ZM6 der BASF AG).

PA(2)

70 Gew.-% Poly($\epsilon$-Caprolactam) $\eta_{rel} = 2,7$ (1 g/100 ml 96 gew.-%ige $H_2SO_4$)

30 Gew.-% Wollastonit

(Ultramid® B3M6 der BASF AG).

PA(3)

61,5 Gew.-% Polyhexamethylenadipinsäureamid $\eta_{rel} = 2,7$

25 Gew.-% Glasfasern

6 Gew.-% roter Phosphor

6 Gew.-% Schlagzähmodifier (sihe PA(1))

1,5 Gew.-% Zinkoxid

(Ultramid® A3X2 G5 der BASF AG).

PA(4)

59,4 Gew.-% teilaromatisches Copolyamid aufgebaut aus Einheiten, die sich von $\epsilon$-Caprolactam und Terephthalsäure/Hexamethylendiamin ableiten im Gewichtsverhältnis 70:30 (hergestellt nach Beispiel 1 der EP-A 299 444).

16,3 Gew.-% bromiertes Polystyrol mit einem Bromgehalt von 67 % (Pyro-check® 68 PB der Firma Ferro Corp.)

25 Gew.-% Glasfasern

3,8 Gew.-% Antimontrioxid

(Ultramid T Type der BASF AG)

Eine 2,0 mm dicke Platte aus einem Polyamid wurde mit einer Beize, welche die in der Tabelle angegebene Temperatur und Zusammensetzung hatte, über die in der Tabelle angegebenen Zeiträume behandelt. Anschließend wurde die erhaltene Platte mit destilliertem Wasser abgespült und getrocknet.

Die Metallisierung erfolgt in an sich bekannter Weise, wobei als Endresultat eine 25 bis 50 mm dicke Kupferschicht auf der Polyamid-Platte erhalten wurde.

Die Ergebnisse des Rollenschälversuchs nach DIN 53 289 und der Temperaturwechselprüfung nach DIN 53 496 sind ebenfalls in der Tabelle aufgeführt.

Zum Vergleich wurden gleiche Polyamidplatten mit wäßrigen Lösungen anderer Säuren und anderer Konzentrationen (gemäß Tabelle) vorbehandelt und in identischer Weise metallisiert. Die Ergebnisse sind ebenfalls der Tabelle zu entnehmen.

Tabelle 1

| Beispiel | Polyamid | Beize | Volumenverhältnis | Vorbehandlung Temp. °C | Vorbehandlung Zeit min. | Temperaturwechselprüfung Beanspruchungsklasse A | Metallschälfestigkeit [N/mm] |
|---|---|---|---|---|---|---|---|
| 1 | (1) | Propylenglykol-1-methylether/37 gew.-%ige HCl | 2:1 | 23 | 15 | bestanden | ≥ 2 |
| 2 | (2) | Propylenglykol-1-methylether/37 gew.-%ige HCl | 2:1 | 23 | 15 | bestanden | ≥ 2 |
| 3 | (3) | Propylenglykol-1-methylether/37 gew.-%ige HCl | 2:1 | 23 | 15 | bestanden | ≥ 1 |
| 4 | (1) | Propylenglykol-1-methylether/37 gew.-%ige HCl | 1:1 | 23 | 10 | bestanden | ≥ 1 |
| 5 | (2) | Propylenglykol-1-methylether/37 gew.-%ige HCl | 1:1 | 23 | 10 | bestanden | ≥ 1 |
| 6 | (3) | Propylenglykol-1-methylether/37 gew.-%ige HCl | 1:1 | 23 | 10 | bestanden | ≥ 1 |
| 7 | (1) | Propylenglykol-1-methylether/37 gew.-%ige HCl | 1:2 | 23 | 5 | bestanden | ≥ 1 |
| 8 | (2) | Propylenglykol-1-methylether/37 gew.-%ige HCl | 1:2 | 23 | 5 | bestanden | ≥ 1 |

Tabelle 1 (Fortsetzung)

| Beispiel | Polyamid | Beize | Volumenverhältnis | Vorbehandlung Temp. °C | Vorbehandlung Zeit min. | Temperaturwechselprüfung Beanspruchungsklasse A | Metallschälfestigkeit [N/mm] |
|---|---|---|---|---|---|---|---|
| 9 | (3) | Propylenglykol-1-methylether/37 gew.-%ige HCl | 1:2 | 23 | 5 | bestanden | ≥ 2 |
| V1 | (4) | Propylenglykol-1-methylether/37 gew.-%ige HCl | 2:1 | 23 | 5 | - | < 0,5 |
| V2 | (4) | Propylenglykol-1-methylether/37 gew.-%ige HCl | 1:1 | 23 | 10 | - | < 0,5 |
| V3 | (4) | Propylenglykol-1-methylether/37 gew.-%ige HCl | 1:2 | 23 | 15 | - | < 0,5 |
| 10 | (1) | Dipropylenglykol-monomethylether/37 gew.-%ige HCl | 2:1 | 23 | 20 | bestanden | ≥ 1 |
| 11 | (2) | Dipropylenglykol-monomethylether/37 gew.-%ige HCl | 2:1 | 23 | 20 | bestanden | ≥ 1 |
| 12 | (3) | Dipropylenglykol-monomethylether/37 gew.-%ige HCl | 2:1 | 23 | 20 | bestanden | ≥ 1 |

Tabelle 1 (Fortsetzung)

| Beispiel | Polyamid | Beize | Volumenverhältnis | Vorbehandlung Temp. °C | Vorbehandlung Zeit min. | Temperaturwechselprüfung Beanspruchungsklasse A | Metallschälfestigkeit [N/mm] |
|---|---|---|---|---|---|---|---|
| 13 | (1) | Dipropylenglykol-monomethylether/37 gew.-%ige HCl | 1:1 | 23 | 15 | bestanden | ≥ 1 |
| 14 | (2) | Dipropylenglykol-monomethylether/37 gew.-%ige HCl | 1:1 | 23 | 15 | bestanden | ≥ 1 |
| 15 | (3) | Dipropylenglykol-monomethylether/37 gew.-%ige HCl | 1:1 | 23 | 15 | bestanden | ≥ 1 |
| 16 | (1) | Dipropylenglykol-monomethylether/37 gew.-%ige HCl | 1:2 | 23 | 10 | bestanden | ≥ 1 |
| 17 | (2) | Dipropylenglykol-monomethylether/37 gew.-%ige HCl | 1:2 | 23 | 10 | bestanden | ≥ 1 |
| 18 | (3) | Dipropylenglykol-monomethylether/37 gew.-%ige HCl | 1:2 | 23 | 10 | bestanden | ≥ 1 |

Tabelle 1 (Fortsetzung)

| Beispiel | Polyamid | Beize | Volumenverhältnis | Vorbehandlung Temp. °C | Vorbehandlung Zeit min. | Temperaturwechselprüfung Beanspruchungsklasse A | Metallschälfestigkeit [N/mm] |
|---|---|---|---|---|---|---|---|
| V4 | (4) | Dipropylenglykol-monomethylether/37 gew.-%ige HCl | 2:1 | 23 | 20 | - | < 0,5 |
| V5 | (4) | Dipropylenglykol-monomethylether/37 gew.-%ige HCl | 1:1 | 23 | 15 | - | < 0,5 |
| V6 | (4) | Dipropylenglykol-monomethylether/37 gew.-%ige HCl | 1:2 | 23 | 10 | - | < 0,5 |
| V7 | (1) | Propylenglykol-1-methylether/10 gew.-%ige HCl | 1:2 | 23 | 15 | nicht bestanden | < 0,5 |
| V8 | (1) | Propylenglykol-1-methylether/10 gew.-%ige HCl | 1:2 | 40 | 15 | bestanden | < 0,5 |
| V9 | (1) | Propylenglykol-1-methylether/10 gew.-%ige HCl | 2:1 | 23 | 15 | nicht bestanden | < 0,5 |
| V10 | (1) | Propylenglykol-1-methylether/10 gew.-%ige HCl | 2:1 | 40 | 15 | nicht bestanden | < 0,5 |
| V11 | (1) | Propylenglykol-1-methylether/70 gew.-%ige HCOOH | 1:2 | 23 | 15 | nicht bestanden | < 0,3 |

Tabelle 1 (Fortsetzung)

| Beispiel | Polyamid | Beize | Volumenverhältnis | Vorbehandlung Temp. °C | Zeit min. | Temperaturwechselprüfung Beanspruchungsklasse A | Metallschälfestigkeit [N/mm] |
|---|---|---|---|---|---|---|---|
| V12 | (1) | Propylenglykol-1-methylether/70 gew.-%ige HCOOH | 1:2 | 40 | 15 | nicht bestanden | < 0,3 |
| V13 | (1) | Propylenglykol-1-methylether/70 gew.-%ige $H_3PO_4$ | 1:2 | 20 | 15 | nicht bestanden | < 0,5 |
| V14 | (1) | ohne Vorbehandlung | | | | nicht bestanden | keinerlei Haftung |
| V15 | (1) | Chromschwefelsäure | | 23 | 6 | nicht bestanden | < 0,1 |
| V16 | (1) | Schwefelsäure 45 Gew.-% | | 40 | 30 | nicht bestanden | < 0,1 |
| V17 | (1) | 50 Gew.-% $HNO_3$ | | 23 | 5 | nicht bestanden | < 0,1 |
| V18 | (1) | 37 Gew.-% HCl | | 23 | 30 | nicht bestanden | < 0,3 |
| V19 | (1) | 37 Gew.-% HCl | | 40 | 10 | nicht bestanden | < 0,3 |
| V20 | (1) | Oxalsäure (gesättigte Lösung) | | 60 | 10 | nicht bestanden | < 0,1 |

Tabelle 1 (Fortsetzung)

| Beispiel | Polyamid | Beize | Volumenverhältnis | Vorbehandlung Temp. °C | Vorbehandlung Zeit min. | Temperaturwechselprüfung Beanspruchungsklasse A | Metallschälfestigkeit [N/mm] |
|---|---|---|---|---|---|---|---|
| V21 | (1) | Borsäure | | 60 | 10 | nicht bestanden | < 0,1 |
| V22 | (1) | Essigsäure (konz.) | | 70 | 60 | nicht bestanden | < 0,3 |
| V23 | (1) | Trichloressigsäure (konz.) | | 23 | 15 | nicht bestanden | < 0,3 |
| V24 | (1) | 70 Gew.-% $H_3PO_4$ | | 23 | 20 | nicht bestanden | < 0,5 |

**Patentansprüche**

1. Verfahren zur Oberflächenbehandlung von Formkörpern auf der Basis von Polyamiden durch Behandlung mit wäßrigen Säuren, dadurch gekennzeichnet, daß man Mischungen aus mindestens 20 gew.-%iger wäßriger Salzsäure mit Mono -oder Diethern einer aliphatischen mehrfunktionellen Hydroxyverbindung im Mischungsverhältnis von 90:10 bis 10:90 Vol.-% verwendet.

**2.** Verfahren nach Anspruch 1, dadurch gekennzeichnet, daß man die Behandlung bei Temperaturen von 10 bis 80 °C durchführt.

**3.** Verfahren nach den Ansprüchen 1 oder 2, dadurch gekennzeichnet, daß man die Behandlung über einen Zeitraum von 0,5 bis 25 Minuten durchführt.

**4.** Verfahren nach den Ansprüchen 1 bis 3, dadurch gekennzeichnet, daß man Mono- oder Diether einer aliphatischen mehrfunktionellen Hydroxyverbindung der allgemeinen Formel I verwendet:

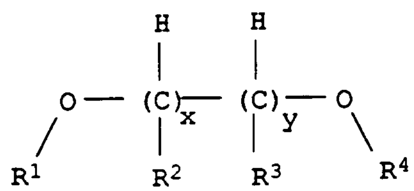 I

wobei

- $R^1$ Wasserstoff oder eine $C_1$- bis $C_{10}$-Alkylgruppe,
- $R^2$ Wasserstoff oder eine $C_1$- bis $C_{10}$-Alkylgruppe oder eine Hydroxylgruppe,
- $R^3$ Wasserstoff oder eine $C_1$- bis $C_{10}$-Alkylgruppe,
- $R^4$ Wasserstoff oder eine $C_1$- bis $C_{10}$-Alkylgruppe oder eine $-(CH_2)_n-OR^5$-Gruppe,
- $R^5$ Wasserstoff oder eine $C_1$- bis $C_{10}$-Alkylgruppe,
- x eine ganze Zahl von 1 bis 10,
- y 0 oder 1,
- n eine ganze Zahl von 2 bis 4

bedeutet.

**5.** Formkörper, erhältlich gemäß dem Verfahren nach den Ansprüchen 1 bis 4.

**6.** Polyamid-Formkörper, in denen in einer Oberflächenschicht von maximal 100 µm Dicke mindestens 5 mol-% der ursprünglich vorhandenen Aminogruppen durch Reaktion mit HCl modifiziert sind.

**7.** Verwendung der Polyamidformkörper gemäß den Ansprüchen 5 oder 6 zur Lackierung, Bedruckung, Metallisierung, Beklebung und Beflockung.

## Claims

**1.** A process for surface treatment of moldings based on polyamides by treatment with aqueous acids, which comprises using a mixture of at least 20% strength by weight aqueous hydrochloric acid with a mono- or diether of an aliphatic polyfunctional hydroxy compound in a mixing ratio of from 90:10 to 10:90 % by volume.

**2.** A process as claimed in claim 1, wherein the treatment is carried out at from 10 to 80 °C.

**3.** A process as claimed in claim 1 or 2, wherein the treatment is carried out for from 0.5 to 25 minutes.

**4.** A process as claimed in claim 1 or 2 or 3, wherein the mono- or diether of an aliphatic poly-functional hydroxy compound has the general formula I:

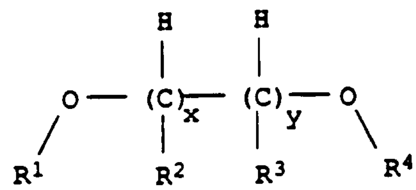

I

where

- $R^1$ is hydrogen or $C_1$- to $C_{10}$-alkyl,
- $R^2$ is hydrogen, $C_1$- to $C_{10}$-alkyl or hydroxyl,
- $R^3$ is hydrogen or $C_1$- to $C_{10}$-alkyl,
- $R^4$ is hydrogen, $C_1$- to $C_{10}$-alkyl or $-(CH_2)_n-OR^5$,
- $R^5$ is hydrogen or $C_1$- to $C_{10}$-alkyl,
- x is an integer from 1 to 10,
- y is 0 or 1, and
- n is an integer from 2 to 4.

**5.** A molding obtainable as claimed in claim 1 or 2 or 3 or 4.

**6.** A polyamide molding in which in a surface layer of not more than 100 µm thickness at least 5 mol% of the amino groups originally present have been modified by reaction with HCl.

**7.** The use of a polyamide molding as claimed in claim 5 or 6 as a coating, printing, metallization, cementing or flocking substrate.

**Revendications**

**1.** Procédé de traitement de la surface de corps moulés à base de polyamides par traitement par des acides aqueux, caractérisé en ce que l'on utilise des mélanges d'acide chlorhydrique aqueux à au moins 20% en poids avec des mono- ou diéthers d'un composé hydroxylé polyfonctionnel aliphatique, dans un rapport de mélange de 90:10 à 10:90% en volume.

**2.** Procédé selon la revendication 1, caractérisé en ce que l'on effectue le traitement à une température de 10 à 80°C.

**3.** Procédé selon la revendication 1 ou 2, caractérisé en ce que l'on effectue le traitement pendant un espace de temps de 0,5 à 25 min.

**4.** Procédé selon l'une quelconque des revendications 1 à 3, caractérisé en ce que l'on utilise des mono- ou diéthers d'un composé hydroxylé polyfonctionnel aliphatique de formule générale I

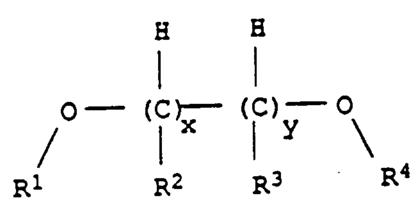

I

dans laquelle

- $R^1$ représente un atome d'hydrogène ou un groupement alkyle en $C_1$-$C_{10}$,
- $R^2$ représente un atome d'hydrogène, un groupement alkyle en $C_1$-$C_{10}$ ou un groupement hydroxy,
- $R^3$ représente un atome d'hydrogène ou un groupement alkyle en $C_1$-$C_{10}$,
- $R^4$ représente un atome d'hydrogène, un groupement alkyle en $C_1$-$C_{10}$ ou un groupement $-(CH_2)_n-OR^5$,

$R^5$ représente un atome d'hydrogène ou un groupement alkyle en $C_1$-$C_{10}$,
x est un nombre entier de 1 à 10,
y est mis pour 0 ou 1,
n est un nombre entier de 2 à 4.

**5.** Corps moulés, obtenus par le procédé selon l'une quelconque des revendications 1 à 4.

**6.** Corps moulés en polyamide, dans lesquels, dans une couche superficielle de 100 µm d'épaisseur au maximum, 5% en moles au moins des groupements amino présents initialement ont été modifiés par réaction avec HCl.

**7.** Utilisation des corps moulés en polyamide selon la revendication 5 ou 6 pour le laquage, l'impression, la métallisation, le collage et le flocage.